# FASCICULE DE BREVET EUROPEEN

(11) **EP 2 855 743 B1**
(45) Date de publication et mention de la délivrance du brevet: **18.05.2016**
(21) Numéro de dépôt: 13731962.0
(22) Date de dépôt: 22.05.2013
(51) Int. Cl.: C30B 29/06, C30B 19/12, C30B 25/20, C30B 25/18

(54) **PROCEDE DE FORMATION D'UNE COUCHE DE SILICIUM EPITAXIEE**
HERSTELLUNGSPROZESS EINER EPITAXIAL SILIZIUMSCHICHT
METHOD OF MANUFACTURING AN EPITAXIAL SILICON LAYER

(30) Priorité: 25.05.2012 FR 1254875
(43) Date de publication de la demande: 08.04.2015
(73) Titulaire: Commissariat à l'Énergie Atomique et aux Énergies Alternatives, 75015 Paris (FR)
(72) Inventeur: GARANDET, Jean-Paul, F-73370 Le Bourget Du Lac (FR); PIHAN, Etienne, F-73290 La Motte Servolex (FR)
(74) Mandataire: Nony
(86) Numéro de dépôt international: PCT/IB2013/054231
(87) Numéro de publication internationale: WO 2013/175411

(56) Documents cités:
- WO-A1-2004/012257
- JP-A- 3 237 093
- JP-A- 2003 092 285
- US-A- 5 344 500
- US-A1- 2005 169 330
- US-A1- 2010 112 792
- PIHAN E ET AL: "Polycrystalline silicon films on ceramic substrates by aluminium-induced crystallisation process", PROCEEDINGS OF THE 3RD WORLD CONFERENCE ON PHOTOVOLTAIC ENERGY CONVERSION : JOINT CONFERENCE OF 13TH PV SCIENCE & ENGINEERING CONFERENCE, 30TH IEEE PV SPECIALISTS CONFERENCE, 18TH EUROPEAN PV SOLAR ENERGY CONFERENCE; OSAKA INTERNATIONAL CONGRESS CENT, 18 mai 2003 (2003-05-18), page 1182, XP031987980, ISBN: 978-4-9901816-0-4
- SCHOLZ M ET AL: "Silver-induced layer exchange for the low-temperature preparation of intrinsic polycrystalline silicon films", APPLIED PHYSICS LETTERS, AIP, AMERICAN INSTITUTE OF PHYSICS, MELVILLE, NY, US, vol. 94, no. 1, 8 janvier 2009 (2009-01-08), pages 12108-12108, XP012118204, ISSN: 0003-6951, DOI: 10.1063/1.3059560
- SHUYUN ZHAO ET AL: "P-17: Metal Induced Continuous Zonal Domain Polycrystalline Silicon and Thin Film Transistors", SID 2007, 2007 SID INTERNATIONAL SYMPOSIUM, SOCIETY FOR INFORMATION DISPLAY, LOS ANGELES, USA, vol. XXXVIII, 20 mai 2007 (2007-05-20), pages 233-235, XP007013492, ISSN: 0007-966X
- SCHNEIDER JENS ET AL: "Depletion regions in the aluminum-induced layer exchange process crystallizing amorphous Si", APPLIED PHYSICS LETTERS, AIP, AMERICAN INSTITUTE OF PHYSICS, MELVILLE, NY, US, vol. 87, no. 3, 12 juillet 2005 (2005-07-12), pages 31905-031905, XP012077152, ISSN: 0003-6951, DOI: 10.1063/1.1996849
- XU YING ET AL: "10.21% polycrystalline silicon thin film solar cells on SiO2 covered c-Si substrates", PROCEEDINGS OF THE 3RD WORLD CONFERENCE ON PHOTOVOLTAIC ENERGY CONVERSION : JOINT CONFERENCE OF 13TH PV SCIENCE & ENGINEERING CONFERENCE, 30TH IEEE PV SPECIALISTS CONFERENCE, 18TH EUROPEAN PV SOLAR ENERGY CONFERENCE; OSAKA INTERNATIONAL CONGRESS CENT, 18 mai 2003 (2003-05-18), page 1276, XP031988005, ISBN: 978-4-9901816-0-4
- FUHS W ET AL: "A novel route to a polycrystalline silicon thin-film solar cell", SOLAR ENERGY, PERGAMON PRESS. OXFORD, GB, vol. 77, no. 6, 1 décembre 2004 (2004-12-01), pages 961-968, XP004661836, ISSN: 0038-092X, DOI: 10.1016/J.SOLENER.2004.05.002
- KANNO H ET AL: "Ge-enhanced MILC velocity in a-Ge/a-Si/SiO2 layered structure", MATERIALS SCIENCE IN SEMICONDUCTOR PROCESSING, ELSEVIER SCIENCE PUBLISHERS B.V., BARKING, UK, vol. 8, no. 1-3, 1 février 2005 (2005-02-01), pages 83-88, XP027849231, ISSN: 1369-8001 [extrait le 2005-02-01]
- "Polycrystalline silicon formation by pulsed rapid thermal annealing of amorphous silicon", APPLIED PHYSICS LETTERS, AIP, AMERICAN INSTITUTE OF PHYSICS, MELVILLE, NY, US, vol. 69, no. 8, 19 août 1996 (1996-08-19), page 1092, XP012017231, ISSN: 0003-6951, DOI: 10.1063/1.117068
- HARTMANN J M ET AL: "Growth kinetics of Si on fullsheet, patterned and silicon-on-insulator substrates", JOURNAL OF CRYSTAL GROWTH, ELSEVIER, AMSTERDAM, NL, vol. 257, no. 1-2, 1 septembre 2003 (2003-09-01), pages 19-30, XP004450878, ISSN: 0022-0248, DOI: 10.1016/S0022-0248(03)01380-0
- MULLER M ET AL: "Silicon LPE on substrates from metallurgical silicon feedstock for large scale production", PROCEEDINGS OF THE 3RD WORLD CONFERENCE ON PHOTOVOLTAIC ENERGY CONVERSION : JOINT CONFERENCE OF 13TH PV SCIENCE & ENGINEERING CONFERENCE, 30TH IEEE PV SPECIALISTS CONFERENCE, 18TH EUROPEAN PV SOLAR ENERGY CONFERENCE; OSAKA INTERNATIONAL CONGRESS CENT, 18 mai 2003 (2003-05-18), page 1221, XP031987990, ISBN: 978-4-9901816-0-4

## Description

La présente invention se rapporte à un nouveau procédé de formation d'une couche de silicium épitaxiée, de bonne qualité, formée de cristallites de taille supérieure ou égale à 20 µm, à partir d'une couche de silicium cristallisé présentant une surface inhomogène en termes de taille de cristallites.

Le silicium cristallisé sous la forme de grains de taille supérieure à 20 µm est en effet particulièrement intéressant pour ses propriétés semi-conductrices dans le cadre de l'élaboration des cellules photovoltaïques.

Actuellement, les cellules photovoltaïques sont majoritairement fabriquées à partir de silicium monocristallin ou polycristallin. La filière de production de silicium cristallin la plus courante met en jeu la solidification de lingots à partir d'un bain de silicium liquide. Ces lingots sont ensuite découpés en plaquettes qui peuvent être transformées en cellules photovoltaïques. Malheureusement, le sciage des lingots entraîne une perte de matière silicium de l'ordre de 50 %. Pour des raisons évidentes, cette perte de matière liée au sciage est préjudiciable aux rendements de production.

Pour éviter la perte de matière générée lors du sciage de ces lingots en plaquettes, des techniques ont été développées en vue d'élaborer directement des plaquettes de silicium.

Toutefois, les méthodes proposées pour élaborer le silicium sous forme de plaquettes ou de rubans d'épaisseur typique variant entre 100 et 500 µm (Edge-defined Film-fed Growth, Ribbon Against Drop et Ribbon Growth on Substrate) ne donnent pas totalement satisfaction notamment au regard des problèmes de coût et/ou de contrôle de procédé qu'elles soulèvent.

Une autre option pour s'affranchir du problème de perte de matière en silicium est de mettre en oeuvre les techniques d'épitaxie en phase liquide (LPE ou en langue anglaise «Liquid Phase Epitaxy» [1], [2]) ou gazeuse (CVD ou en langue anglaise « Chemical Vapour Déposition » [3]). Ces techniques permettent d'obtenir des couches de plusieurs dizaines de micromètres d'épaisseur et de bonne qualité cristalline, avec un coût modéré et des vitesses de solidification élevées (typiquement de 0,1 à 5 µm/min).

Malheureusement, ces techniques imposent généralement, pour obtenir des couches de qualité suffisante, de mettre en oeuvre des substrats monocristallins et donc coûteux.

Or, dans un souci de réduction des coûts, il est primordial de s'affranchir de l'usage de substrats de silicium monocristallin, au profit de substrats en silicium polycristallin dits substrats à « bas coût ».

Pour la réalisation de tels substrats en silicium polycristallin, il a été proposé une technique basée sur le frittage de poudres de silicium [4]. Cette technique permet de réaliser une plaquette de silicium en deux étapes, la première consistant en un pressage à chaud d'un lit de poudres dans un moule, et la seconde, en un frittage thermique. Toutefois, pour permettre un frittage efficace, la taille des cristallites de départ doit être submicronique, et la maturation au cours du procédé ne permet pas d'obtenir des grains de taille supérieure à 2 µm, même après plusieurs heures à 1350 °C [5]. Des tailles aussi faibles sont rédhibitoires pour les applications mettant en oeuvre des substrats dans le domaine photovoltaïque.

Pour suppléer à ce défaut, divers procédés de recristallisation de grains basés sur la mise en oeuvre d'une phase liquide ont été proposés. Par exemple, Reber *et al*. [3] propose un procédé consistant à chauffer la surface d'une plaquette frittée par lampes Infra Rouge ou Laser pour fondre en surface le silicium sur une épaisseur de l'ordre de 10-20 µm, le silicium liquide recristallisant ensuite sous forme de grains de taille millimétrique au refroidissement.

Plus récemment, comme alternative au procédé de Reber *et al.,* une technique originale et particulièrement avantageuse, basée sur la recristallisation en solvant liquide de plaquettes de poudres frittées a été développée. Cette technique consiste plus particulièrement à soumettre une plaquette frittée de silicium, dont les cristallites sont de petite taille (typiquement de l'ordre du micromètre), à un traitement thermique à haute température, mais inférieure à la température de fusion du silicium, en présence d'un solvant métallique. Ce solvant assure un transport efficace du silicium en phase liquide, ce qui permet de faire grossir les gros cristallites au détriment des plus petits.

Ainsi, il est possible, *via* ce procédé, de réaliser des couches de silicium cristallisé à gros cristallites et d'épaisseur pouvant dépasser la centaine de micromètres.

Toutefois, les gros cristallites ne pavent pas la totalité de la surface de la couche de silicium cristallisé ainsi obtenue, cette dernière comportant à la fois des gros cristallites de taille supérieure à 20 µm et des petits cristallites de taille inférieure.

Une telle surface, mise en oeuvre comme substrat pour l'épitaxie de silicium, ne permet malheureusement pas la croissance d'une couche de silicium de qualité satisfaisante pour des applications dans le domaine photovoltaïque.

La présence invention vise précisément à proposer un nouveau procédé permettant de former une couche de silicium épitaxiée, de bonne qualité, à partir d'une couche de silicium cristallisé dont seule une fraction surfacique est formée de gros cristallites, le reste de la surface étant constitué de cristallites de taille inférieure.

Ainsi, la présente invention concerne un procédé de formation d'une couche de silicium épitaxiée formée de cristallites ayant une taille supérieure ou égale à 20 µm, comprenant au moins les étapes consistant à :
(1) disposer d'une couche de silicium cristallisé dont la surface, inhomogène en termes de taille de cristallites, est formée :
   - de gros cristallites de taille supérieure ou égale à 20 µm, répartis sur ladite surface de manière non continue, l'espacement latéral moyen entre deux gros cristallites voisins n'excédant pas 200 µm ; et
   - de petits cristallites de taille inférieure à celle des gros cristallites, présents en une fraction surfacique n'excédant pas 60 % de ladite surface ;
(2) constituer, à la surface de ladite couche de silicium inhomogène, une couche d'au moins un matériau non nucléant pour le silicium et dont l'épaisseur est ajustée pour recouvrir l'intégralité de la surface externe desdits petits cristallites tout en laissant accessible tout ou partie de la surface externe desdits gros cristallites ; et
(3) réaliser la croissance épitaxiale d'une couche de silicium à la surface de l'ensemble obtenu à l'issue de l'étape (2), dans des conditions propices à la formation de ladite couche épitaxiée attendue.

Les inventeurs ont ainsi découvert qu'il est possible de réaliser, *via* un tel procédé, une croissance épitaxiale de bonne qualité. La couche de silicium épitaxiée obtenue à l'issue du procédé de l'invention est formée très majoritairement de cristallites de taille supérieure ou égale à 20 µm.

Egalement, le procédé de l'invention autorise avantageusement la mise en oeuvre de toute technique classique d'épitaxie, qu'il s'agisse d'une technique d'épitaxie en phase gazeuse (CVD) ou en phase liquide (LPE).

Par ailleurs, le procédé de l'invention s'inscrit parfaitement dans le cadre de la réalisation de dispositifs photovoltaïques. Le matériau non nucléant pour le silicium, lorsqu'il s'agit d'un matériau de type céramique réfractaire, peut ainsi être avantageusement intégré à un dispositif photovoltaïque, en constituant une structure maximisant la réflectivité en face arrière de la couche de silicium épitaxiée obtenue à l'issue du procédé de l'invention.

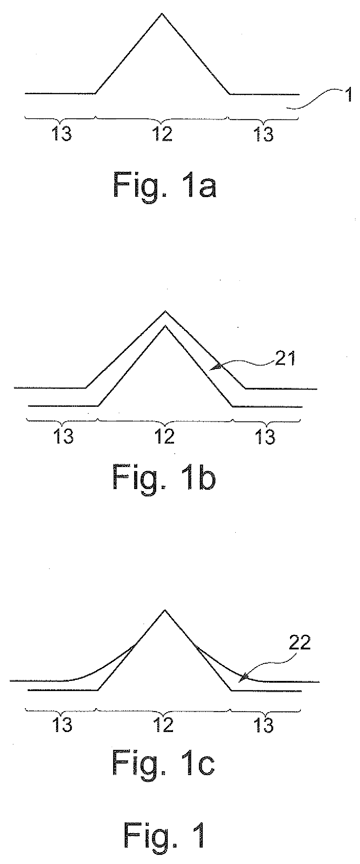

D'autres caractéristiques, avantages et modes d'application du procédé selon l'invention ressortiront mieux à la lecture de la description qui va suivre, donnée à titre illustratif et non limitatif, et en particulier en référence à la Figure 1 annexée.

Plus précisément, comme développé par la suite, la Figure 1 représente, de manière schématique et en coupe transversale, les structures obtenues aux différents stades de la mise en oeuvre d'un procédé conforme à l'invention.

Il convient de noter que, pour des raisons de clarté, les différents éléments sur la Figure 1 sont représentés en échelle libre, les dimensions réelles des différentes parties n'étant pas respectées.

Dans la suite du texte, les expressions « compris entre ... et ... », « allant de ... à ... » et « variant de ... à ... » sont équivalentes et entendent signifier que les bornes sont incluses, sauf mention contraire.

Sauf indication contraire, l'expression « comportant/comprenant un(e) » doit être comprise comme « comportant/comprenant au moins un(e) ».

### ETAPE (1): COUCHE DE SILICIUM CRISTALLISE

Comme évoqué précédemment, le procédé de l'invention met en oeuvre une couche de silicium cristallisé présentant une surface inhomogène en termes de taille de cristallites.

Plus précisément, ladite surface présente des cristallites de taille supérieure ou égale à 20 µm ne couvrant pas entièrement la surface, le reste de ladite surface étant formée de cristallites de taille inférieure.

Dans la suite du texte, on désignera, sous l'appellation « gros cristallites », les cristallites de taille supérieure ou égale à 20 µm et, à l'inverse, sous l'appellation « petits cristallites », les cristallites de taille inférieure, c'est-à-dire de taille strictement inférieure à 20 µm.

Les gros cristallites peuvent plus particulièrement présenter une taille allant de 30 à 150 µm, en particulier de 60 à 100 µm

La taille des cristallites peut être définie au sens de l'invention par la racine carrée de la surface (avec, par exemple, une unité de surface en µm²) dudit cristallite.

La surface d'un cristallite peut par exemple être déduite à partir d'une analyse d'image obtenue par microscopie optique ou par microscopie électronique à balayage (MEB).

Comme évoqué précédemment, les gros cristallites sont répartis sur la surface de manière non continue. Autrement dit, de manière générale, deux gros cristallites ne sont pas contigus, et sont plus particulièrement espacés dans le cadre de la présente invention par des zones occupées par des petits cristallites. En particulier, l'espacement latéral moyen entre deux gros cristallites voisins n'excède pas 200 µm. En particulier, il peut aller de 1 à 200 µm, et plus particulièrement de 20 à 100 µm.

Les cristallites de taille inférieure, dits « petits cristallites », peuvent plus particulièrement présenter une taille inférieure à 10 µm, en particulier allant de 0,2 à 5 µm.

Ils représentent une fraction surfacique inférieure ou égale à 60 % de la surface de ladite couche de silicium.

En particulier, la fraction surfacique desdits petits cristallites peut aller de 1 à 60 %, et plus particulièrement de 10 à 40 %, de ladite surface.

Comme pour la taille des cristallites, la fraction surfacique peut être obtenue par analyse d'image obtenue par MEB ou par microscopie optique, en calculant la surface occupée par les cristallites.

Ladite couche de silicium cristallisé mise en oeuvre en étape (1) peut présenter une épaisseur allant de 100 à 1000 µm, en particulier de 300 à 600 µm

Selon une variante particulière de l'invention, lesdits gros cristallites de la surface sont de forme pyramidale.

Bien entendu, on entend par « forme pyramidale », une forme approximativement pyramidale.

Une telle variante est plus particulièrement illustrée en Figure 1a, sur laquelle est représentée en coupe transversale une couche de silicium cristallisé (1) présentant en surface un gros cristallite (12) de forme pyramidale et, de part et d'autre dudit gros cristallite, des zones de surface occupées par des petits cristallites (13).

### Préparation de la couche de Silicium cristallisé

La couche de silicium cristallisé de l'étape (1) peut être préparée préalablement à sa mise en oeuvre dans le procédé de l'invention.

Le développement qui suit décrit, à titre d'exemple, un procédé de préparation d'une telle couche de silicium cristallisé.

Celle-ci peut, par exemple, être obtenue à partir d'un substrat de silicium peu onéreux, à l'image du silicium fritté *via* un processus contrôlé de maturation des grains de silicium mis au contact d'une composition formée en tout ou partie d'un solvant métallique en fusion et selon un processus thermique spécifique.

Plus particulièrement, cette couche de silicium cristallisé peut être obtenue à partir d'une couche de silicium à (re)cristalliser dont la taille moyenne des grains est inférieure à 5 µm, par :
- mise en contact de ladite couche à (re)cristalliser, en particulier frittée, avec une composition liquide formée en tout ou partie d'au moins un solvant métallique ; et
- exposition de l'ensemble à un traitement thermique propice à la (re)cristallisation de ladite couche de silicium à la taille de cristallites attendue, ledit traitement thermique comprenant le chauffage de l'ensemble formé par la couche de silicium au contact de ladite composition liquide à une température inférieure à 1410°C et au moins égale à la température eutectique dans le diagramme de phases solvant-silicium.

La composition liquide mise en oeuvre peut être formée d'un ou plusieurs solvant(s) métallique(s), et, le cas échéant, d'un ou plusieurs autres matériaux annexes.

Le ou lesdits solvant(s) métallique(s) peu(ven)t par exemple être choisi(s) parmi l'indium, l'étain, le cuivre, le gallium et leurs alliages.

A titre de matériau annexe, on peut citer notamment le silicium solide, en particulier présent en une teneur allant de 0 à 4 % en poids, de préférence de 0 à 2 % en poids par rapport au poids total de la composition liquide.

La composition liquide peut incorporer en outre un ou plusieurs agent(s) dopant(s) de type P, comme par exemple l'aluminium (Al), le gallium (Ga), l'indium (In), le bore (B), ou de type N, comme par exemple l'antimoine (Sb), l'arsenic (As), le phosphore (P), et leurs mélanges, notamment en une proportion allant de 0,05 à 5 ppm atomique, préférentiellement 0,1 à 1 ppm atomique.

Ladite composition liquide peut être formée préalablement à sa mise en contact avec ladite couche de silicium à (re)cristalliser.

Alternativement, elle peut être formée directement au contact de ladite couche de silicium à (re)cristalliser *via* la fourniture en surface de ladite couche de silicium, d'une composition en phase solide comprenant au moins un solvant métallique destiné à former ladite composition liquide, et le chauffage de l'ensemble à une température au moins égale à la température eutectique dans le diagramme de phases solvant-silicium et inférieure à 1410°C.

Par exemple, ladite composition liquide peut être formée en surface de ladite couche de silicium à (re)cristalliser *via* le dépôt en surface de ladite couche de silicium, d'indium solide suivi du chauffage de l'ensemble à une température de 1000°C.

Le traitement thermique requiert une température propice à l'évaporation du solvant métallique liquide et donc à l'obtention d'une sursaturation en silicium de ladite composition liquide.

Comme précisé ci-dessus, l'ensemble formé par la couche de silicium à (re)cristalliser et la composition à base de solvant(s) métallique(s) subit un traitement thermique propice à la maturation des grains à (re)cristalliser.

De manière avantageuse, l'étape de traitement thermique peut être réalisée en maintenant une température constante permettant la vaporisation de la totalité dudit solvant métallique liquide, en particulier variant de 800°C à 1350 °C, notamment de 1000 °C à 1200 °C.

A titre d'exemples, la formation de ladite couche de silicium (re)cristallisée peut être réalisée à l'aide d'une composition liquide d'étain et de silicium, dont la température est maintenue entre 1050 °C et 1150 °C, ou encore à l'aide d'une composition liquide d'indium, dont la température est maintenue entre 950 °C et 1050 °C.

Cette étape de traitement thermique peut être réalisée par toute technique de chauffage connue de l'homme du métier et classiquement mise en oeuvre pour l'élaboration des cellules photovoltaïques, par exemple dans un four à passage ou encore, un four à chauffage résistif.

De préférence, les étapes de mise en contact avec la composition liquide et de traitement thermique sont réalisées simultanément.

Un tel procédé conduit à une couche de silicium répondant aux spécificités décrites précédemment, les gros cristallites présentant en particulier une morphologie en pyramides.

### ETAPE (2): COUCHE DE MATERIAU NON NUCLEANT POUR LE SILICIUM

Selon une seconde étape du procédé de l'invention, il est formé, à la surface de ladite couche de silicium cristallisé décrite précédemment, une couche d'au moins un matériau non nucléant pour le silicium, dont l'épaisseur est ajustée pour recouvrir l'intégralité de la surface externe desdits petits cristallites et laisser accessible tout ou partie de la surface externe desdits gros cristallites.

Par surface « accessible », on entend désigner le fait que la surface externe desdits gros cristallites est, au moins en partie, non revêtue par ladite couche de matériau non nucléant, c'est-à-dire reste en contact direct avec l'atmosphère environnante.

Selon un mode de réalisation particulier, une telle couche de matériau non nucléant présentant l'épaisseur ajustée souhaitée peut être réalisée *via* les étapes consistant en :
(i) former une couche d'au moins un matériau non nucléant pour le silicium sur ladite surface de l'étape (1), ladite couche recouvrant au moins l'intégralité de la surface externe desdits petits cristallites ; et
(ii) exposer ladite surface revêtue de l'étape (i) à un traitement de surface propice à l'élimination de la couche de matériau non nucléant sur tout ou partie de la surface externe desdits gros cristallites.

Ces étapes sont développées dans la suite du texte, en particulier en référence aux Figures 1b et 1c annexées.

### Etape (i) : formation d'une couche de matériau non nueléant pour le silicium

Par « matériau non nucléant pour le silicium », on entend désigner un matériau apte à limiter la nucléation du silicium. De tels matériaux sont bien connus de l'homme du métier. Ils sont généralement caractérisés par un angle de mouillage avec le silicium solide supérieur à 90°.

Selon un mode de réalisation particulier, le matériau non nucléant pour le silicium est un matériau céramique.

Il peut être plus particulièrement choisi parmi les composés de formule générale SiOₓN_{y}C_{z}, avec x étant supérieur ou égal 0,1, de préférence, supérieur ou égal à 0,3, y et z étant chacun supérieur ou égal à 0.

Selon un mode de réalisation particulier, la couche dudit matériau non nucléant de l'étape (i) peut être formée par :
(a) mise en contact de ladite surface à traiter avec un ou plusieurs précurseurs dudit matériau non nucléant pour le silicium ; et
(b) traitement thermique de l'ensemble formé par ladite surface en contact avec le ou lesdits précurseurs, propice à la formation de ladite couche de matériau non nucléant ; les étapes (a) et (b) étant consécutives ou simultanées.

Par « précurseur du matériau non nucléant », on entend un composé apte à conduire, par traitement thermique, audit matériau non nucléant.

En particulier, dans le cas de la formation d'oxydes, nitrures ou carbures de silicium en tant que matériaux non nucléants, le ou lesdits précurseurs peuvent être choisis parmi les polymères organosiliciés.

La couche de matériau non nucléant peut ainsi être obtenue par décomposition thermique desdits polymères organosiliciés.

Selon un mode de réalisation particulier, les polymères organosiliciés peuvent être choisis parmi les polysilazane(s) et/ou polysiloxane(s).

Selon une première variante de réalisation de l'invention, le matériau non nucléant pour le silicium dérive de la décomposition thermique de polysilazane(s).

Les polysilazanes sont des polymères organosiliciés dont le squelette principal consiste en un enchaînement d'atomes de silicium et d'azote.

Les polysilazanes convenant à l'invention peuvent être représentés par la formule suivante -(SiR'R"-NR'")ₙ-(SiR*R**-NR***)ₚ-, dans laquelle R', R", R'", R*, R** et R*** représentent indépendamment les uns des autres un atome d'hydrogène ou un radical alkyle, aryle, vinyle ou (trialkoxysilyl)alkyle substitué ou non-substitué, n et p ayant des valeurs telles que le polysilazane présente un poids moléculaire moyen allant de 150 à 150 000 g/mol.

De tels polysilazanes sont notamment décrits dans le document US 2009/0286086. A titre d'exemple, on peut citer les perhydropolysilazanes commercialisés par la société Clariant.

Selon une autre variante de réalisation de l'invention, le matériau non nucléant pour le silicium dérive de la décomposition thermique de polysiloxane(s).

Les polysiloxanes sont des polymères organosiliciés dont le squelette principal consiste en un enchaînement d'atomes de silicium et d'oxygène.

Les polysiloxanes convenant à l'invention peuvent être représentés par la formule suivante (SiR₁R₂-O)ₖ-(SiR₃R₄-O)ₘ dans laquelle R₁, R₂, R₃ et R₄ représentent indépendamment les uns des autres H, CH₃, C₂H₅, C₆H₅, CH₂=CH-, etc., k et m sont compris entre 1 et 1000.

De tels polysiloxanes sont par exemple décrits dans le document CA 1296468. A titre d'exemple, on peut citer les polyalkylsiloxanes commercialisés sous la référence FOₓ^{®} (Flowable Oxides) par la société Dow Corning.

De préférence, les polymères organosiliciés sont choisis parmi les polyalkylsiloxanes et les perhydropolysilazanes.

Le ou lesdits précurseurs dudit matériau non nucléant, en particulier les polymères organosiliciés décrits précédemment, peuvent être mis en oeuvre en solution liquide.

La solution de précurseurs dudit matériau non nucléant peut comprendre, outre le ou lesdits précurseurs, un solvant, par exemple un solvant anhydre aprotique, et, le cas échéant, un initiateur de polymérisation, par exemple de type peroxyde organique.

A titre de solvant anhydre aprotique, on peut notamment citer le toluène, le diméthylformamide, le diméthylsulfoxyde et le dibutyléther.

A titre d'initiateur de polymérisation, on peut notamment citer le peroxyde de dicumyle, le diperoxyester, le peroxycarbonate ou l'acétylacétate de zirconium.

De préférence, la solution de polysilazane(s) et/ou polysiloxane(s) utilisée selon l'invention comprend de 10 à 90 % en poids de polysilazane(s) et/ou de polysiloxane(s) par rapport au poids total de ladite solution, en particulier de 20 à 80 % en poids, et plus particulièrement de 40 à 60 % en poids.

La mise en contact en étape (a) de la surface avec la solution comprenant le ou lesdits précurseurs du matériau non nucléant peut être effectuée par toute technique conventionnelle connue de l'homme du métier. Par exemple, elle peut être déposée par trempage, par tournage, par pistolétage ou application au pinceau.

De préférence, elle est effectuée par tournage (ou « spin coating » en langue anglaise).

Le traitement thermique de l'étape (b) peut comprendre plus particulièrement le chauffage de l'ensemble formé par ladite surface en contact avec le ou lesdits précurseurs, à une température propice à la formation de ladite couche de matériau non nucléant, et plus particulièrement, dans le cadre de la mise en oeuvre d'une solution de polymères organosiliciés comme précurseurs, à une température propice à la condensation-réticulation desdits polymères.

Il appartient aux connaissances de l'homme du métier d'adapter les conditions opératoires pour former de la couche de matériau non nucléant. En particulier, il faudra veiller à obtenir une couche de matériau non nucléant de pureté élevée, en vue de sa mise en oeuvre dans des dispositifs photovoltaïques.

Ainsi, l'étape (b) de traitement thermique peut être effectuée à une température allant de 300 à 700 °C, en particulier de 400 à 600 °C.

Le chauffage est de préférence opéré sous atmosphère contrôlée, en particulier sous atmosphère d'azote ou sous air.

Ce traitement thermique peut être réalisé pendant une durée d'au moins 30 minutes, en particulier d'au moins 1 heure.

De façon avantageuse, on pourra réaliser, à l'issue de l'étape b), un traitement thermique additionnel à une température d'au moins 1000°C, pendant au moins une heure, sous atmosphère oxydante, pour oxyder en surface la couche obtenue.

Selon un mode de réalisation particulier, la couche de matériau non nucléant formée à l'issue de l'étape (i) peut recouvrir l'intégralité de la surface de ladite couche de silicium, c'est-à-dire à la fois la surface externe desdits gros cristallites et celle desdits petits cristallites.

La couche de matériau non nucléant formée à l'issue de l'étape (i) peut présenter une épaisseur allant de 0,05 à 5 µm, en particulier de 0,2 à 2 µm

L'épaisseur de la couche externe peut être déterminée de façon conventionnelle par microscopie électronique à balayage (MEB).

La couche de matériau non nucléant formée à l'issue de l'étape (i) est de préférence d'épaisseur variable, avec une épaisseur moindre en surface desdits gros cristallites par rapport à l'épaisseur en surface desdits petits cristallites.

Une telle variation d'épaisseur de la couche est par exemple obtenue dans le cas où les gros cristallites de surface sont de forme pyramidale. Comme illustré en Figure 1b, la couche de matériau non nucléant (21), obtenue à l'issue de l'étape (i) décrite précédemment, présente en surface desdits gros cristallites (12) une épaisseur globalement inférieure par rapport à celle en surface desdits petits cristallites (13).

### Etape (ii) : traitement de surface

La surface revêtue de la couche de matériau non nucléant obtenue à l'issue de l'étape (i) décrite précédemment est soumise à un traitement de surface propice à l'élimination de la couche de matériau non nucléant sur tout ou partie de la surface externe desdits gros cristallites.

Cette étape de traitement de surface peut être plus particulièrement opérée par attaque chimique. L'homme du métier est à même d'employer les techniques d'attaque chimique connues et d'adapter les conditions opératoires de leur mise en oeuvre pour obtenir la couche de matériau non nucléant souhaitée, laissant libre au moins partiellement la surface externe desdits gros cristallites.

Il peut s'agir d'une attaque chimique par voie humide. Par exemple, dans le cas où le matériau non nucléant est formé d'oxyde de silicium, l'attaque chimique peut être effectuée à l'aide d'une solution d'acide fluorhydrique.

Selon une autre variante de réalisation, il peut s'agir d'une attaque par voie plasma, également appelée voie sèche, par exemple par plasma argon.

Le traitement de surface de l'étape (ii) peut être un traitement localisé ou non, en fonction notamment de l'épaisseur de la couche de matériau formée en étape (i).

Ainsi, dans le cas où le dépôt de matériau non nucléant obtenu à l'étape (i) est d'épaisseur moindre en surface desdits gros cristallites, comme illustré en Figure 1b, le traitement de surface de l'étape (ii) peut être opéré de manière uniforme sur l'ensemble de la surface de ladite couche, de manière à dégager au moins partiellement la surface externe desdits gros cristallites tout en conservant un dépôt de matériau non nucléant en surface desdits petits cristallites.

Le traitement de surface peut être alternativement opéré par attaque directionnelle par plasma, en particulier par plasma argon.

L'attaque directionnelle par plasma est particulièrement avantageuse, du fait de l'anisotropie de la vitesse de gravage, pour enlever localement la couche de matériau non nucléant et dégager ainsi la surface externe desdits gros cristallites.

Par exemple, dans le cas où les gros cristallites sont de forme pyramidale, l'attaque directionnelle par plasma est particulièrement efficace pour enlever la couche de matériau non nucléant en incidence oblique et ainsi découvrir les flancs des cristallites pyramidaux tout en laissant subsister ledit matériau non nucléant en surface des petits cristallites.

A l'issue de ce traitement de surface, comme illustré en Figure 1c, la couche de matériau non nucléant (22) recouvre l'intégralité de la surface externe desdits petits cristallites (13) et laisse accessible, au moins en partie, la surface externe desdits gros cristallites (12).

### ETAPE (3): CROISSANCE EPITAXIALE

Selon une troisième étape du procédé de l'invention, la surface de l'ensemble obtenu à l'issue de l'étape (2) du procédé de l'invention sert de substrat pour la croissance épitaxiale d'une couche de silicium.

Comme évoqué précédemment, cette croissance épitaxiale peut être opérée par toute technique d'épitaxie connue de l'homme du métier.

Ainsi, selon une première variante de réalisation, l'étape (3) peut être effectuée par épitaxie en phase liquide (LPE). Le principe de la LPE est de porter à une température élevée, mais inférieure à la température de fusion du silicium, un bain liquide comprenant le silicium et un solvant. Une fois le substrat à revêtir introduit au contact du bain, le silicium précipite et cristallise sur le substrat, par abaissement progressif de la température du bain (de 0,1 °C/min à 1°C/min).

Par exemple, l'épitaxie en étape (3) peut être réalisée à partir d'un bain liquide comprenant du silicium et de l'étain.

Selon une seconde variante de réalisation, l'étape (3) peut être effectuée par épitaxie en phase gazeuse (CVD). La technologie CVD est quant à elle basée sur la décomposition d'un précurseur gazeux, par exemple du silane ou un chlorosilane, au voisinage du substrat à revêtir.

Par exemple, l'épitaxie en étape (3) peut être réalisée en mettant en oeuvre du trichlorosilane comme précurseur.

Il appartient à l'homme du métier d'ajuster les conditions opératoires, notamment en termes de température et de durée du processus de croissance, pour obtenir la couche de silicium épitaxiée souhaitée.

A l'issue de l'étape (3) du procédé de l'invention, la couche épitaxiée est formée très majoritairement de cristallites de taille supérieure ou égale à 20 µm.

En particulier, la couche de silicium épitaxiée obtenue à l'issue du procédé de l'invention est formée d'au moins 95 % de cristallites ayant une taille supérieure ou égale à 20 µm, par rapport au nombre total de cristallites présents dans la couche de cristallites.

De préférence, la proportion de cristallites ayant une taille supérieure ou égale à 20 µm présents dans la couche de silicium épitaxiée est d'au moins 99 %, et très avantageusement, de 100 %.

De préférence, les cristallites de la couche de silicium épitaxiée obtenue à l'issue de l'étape (3) présentent une taille supérieure ou égale à 50 µm, et plus particulièrement supérieure ou égale à 100 µm.

L'invention va maintenant être décrite au moyen des exemples suivants donnés bien entendu à titre illustratif et non limitatif de l'invention.

### EXEMPLES

### EXEMPLE 1

### i. Couche de silicium cristallisé

Le substrat de départ est obtenu à partir d'une plaquette frittée (taille moyenne des grains de 1 µm) par un traitement de maturation de grains en solvant liquide d'indium, à 1000°C, pendant 4 heures.

A l'issue de ce traitement, le substrat présente une morphologie en pyramides de côté moyen, mesuré par microscopie électronique à balayage (MEB), de 60 µm, et comprend une fraction de surface couverte par des petits grains inaptes au processus d'épitaxie, mesurée par MEB, de 20 %.

### ii. Couche de matériau non nucléant pour le silicium

### Formation d'une couche de matériau non nucléant pour le sicilium

Une couche de FOx-25^{®} commercialisé par Dow Corning (octaméthyltrisiloxane et hexaméthylsiloxane) est déposée par spin coating avec une vitesse de rotation de 1000 tours par minute.

Après un traitement thermique d'1 heure à 400 °C sous atmosphère d'azote, une couche de silice est formée, dont l'épaisseur, mesurée par MEB, est en moyenne de 0,4 µm sur les pyramides, et d'environ 2 µm sur les zones couvertes par des petits grains.

### Traitement de surface

Le substrat revêtu est soumis à une attaque chimique dans une solution d'acide fluorhydrique concentré à 49 %, à une température ambiante, pendant 10 secondes, qui permet de révéler les flancs des pyramides tout en laissant subsister de la silice sur les zones couvertes par les petits grains.

### iii. Croissance épitaxiale

Après attaque chimique, une couche de 20 µm de silicium est déposée par CVD (Chemical Vapor Déposition) à partir d'un précurseur trichlorosilane à 1140 °C. La durée du processus de croissance est d'environ 5 minutes. A l'issue du procédé de dépôt, la taille des grains en surface de la plaquette, mesurée par MEB, est en moyenne de 50 µm.

### EXEMPLE 2

### i. Couche de silicium cristallisé

Le substrat de départ est obtenu à partir d'une plaquette frittée (taille moyenne des grains de 1 µm) par un traitement de maturation de grains en solvant liquide d'étain, à 1100°C, pendant 5 heures.

A l'issue de ce traitement, le substrat présente une morphologie en pyramides de côté moyen, mesuré par MEB, de 80 µm, et comprend une fraction de surface couverte par des petits grains inaptes au processus d'épitaxie, mesurée par MEB, de 35 %.

### ii. Couche de matériau non nucléant pour le silicium

### Formation d'une couche de matériau non nucléant pour le sicilium

Une couche de PHPS (PerHydroPolySilazane), commercialisé par la société Clariant, est déposée par spin coating avec une vitesse de rotation de 2000 tours par minute. Après un traitement thermique d'1 heure à 600 °C sous atmosphère d'azote, une couche d'oxynitrure de silicium est formée, dont l'épaisseur, mesurée par MEB, est en moyenne de 100 nm sur les pyramides, et d'environ 400 nm sur les zones couvertes par des petits grains.

### Traitement de surface

Le substrat revêtu est soumis à un traitement plasma d'argon pendant 1 heure, qui permet de révéler les flancs des pyramides tout en laissant subsister de l'oxynitrure de silicium sur les zones couvertes par des petits grains.

### iii. Croissance épitaxiale

Après attaque chimique, une couche de 40 µm de silicium est déposée par LPE (Liquid Phase Epitaxy) à partir d'une solution d'étain à 1100°C. La durée du processus de croissance est d'environ 4 heures. A l'issue du procédé de dépôt, la taille des grains en surface de la plaquette, mesurée par MEB, est de 100 µm.

### Références

[1] Peter et al., Thin film silicon solar cells on upgraded metallurgical silicon substrates prepared by LPE ; Solar Energy Materials and Solar Cells 74 (2002) 219 ;
[2] Olchowik et al., Influence of LPE process technological conditions on Si ELO layers morphology, J. Non Crystalline Solids 354 (2008) 4287 ;
[3] Reber et al., Crystalline silicon thin film solar cells - recent results at Fraunhoffer ISE, Solar Energy, 77 (2004) 865-875 ;
[4] Demande de brevet WO 2004/093202 ;
[5] Lebrun et al., J. Am. Ceramic. Soc., 1-9 (2012), DOI: 10.1111/j.1551-2916.2011.05052.x.

## Revendications

1. Procédé de formation d'une couche de silicium épitaxiée formée de cristallites ayant une taille supérieure ou égale à 20 µm, comprenant au moins les étapes consistant à :
(1) disposer d'une couche de silicium cristallisé dont la surface, inhomogène en termes de taille de cristallites, est formée :
- de gros cristallites de taille supérieure ou égale à 20 µm, répartis sur ladite surface de manière non continue, l'espacement latéral moyen entre deux gros cristallites voisins n'excédant pas 200 µm ; et
- de petits cristallites de taille inférieure à celle des gros cristallites, présents en une fraction surfacique n'excédant pas 60 % de ladite surface ;
(2) constituer, à la surface de ladite couche de silicium inhomogène, une couche d'au moins un matériau non nucléant pour le silicium et dont l'épaisseur est ajustée pour recouvrir l'intégralité de la surface externe desdits petits cristallites tout en laissant accessible tout ou partie de la surface externe desdits gros cristallites ; et
(3) réaliser la croissance épitaxiale d'une couche de silicium à la surface de l'ensemble obtenu à l'issue de l'étape (2), dans des conditions propices à la formation de ladite couche épitaxiée attendue.

2. Procédé selon la revendication 1, **caractérisé en ce que** lesdits gros cristallites de ladite surface de l'étape (1) sont de forme pyramidale.

3. Procédé selon la revendication 1 ou 2, **caractérisé en ce que** l'espacement latéral moyen entre deux gros cristallites voisins de ladite surface de l'étape (1) va de 1 à 200 µm, en particulier de 20 à 100 µm.

4. Procédé selon l'une quelconque des revendications précédentes, **caractérisé en ce que** la fraction surfacique desdits petits cristallites de l'étape (1) va de 1 à 60 %, en particulier de 10 à 40 %, de ladite surface.

5. Procédé selon l'une quelconque des revendications précédentes, dans lequel l'étape (2) comprend au moins les étapes consistant en :
(i) former une couche d'au moins un matériau non nucléant pour le silicium sur ladite surface de l'étape (1), ladite couche recouvrant au moins l'intégralité de la surface externe desdits petits cristallites ; et
(ii) exposer ladite surface revêtue de l'étape (i) à un traitement de surface propice à l'élimination de la couche de matériau non nucléant sur tout ou partie de la surface externe desdits gros cristallites.

6. Procédé selon l'une quelconque des revendications précédentes, dans lequel ledit matériau non nucléant pour le silicium est un matériau céramique, en particulier choisi parmi les composés de formule générale SiOₓN_{y}C_{z}, avec x étant supérieur ou égal 0,1, de préférence, supérieur ou égal à 0,3, y et z étant chacun supérieur ou égal à 0.

7. Procédé selon la revendication 5 ou 6, dans lequel l'étape (i) comprend (a) la mise en contact de ladite surface à traiter avec un ou plusieurs précurseurs dudit matériau non nucléant, en particulier choisi(s) parmi les polymères organosiliciés, et (b) le traitement thermique de l'ensemble formé par ladite surface en contact avec le ou lesdits précurseurs, propice à la formation de ladite couche de matériau non nucléant, en particulier par condensation-réticulation, les étapes (a) et (b) étant consécutives ou simultanées.

8. Procédé selon la revendication précédente, dans lequel le ou lesdits polymère(s) organosilicié(s) est/sont choisi(s) parmi les polysilazane(s) et/ou polysiloxane(s), et plus particulièrement parmi les polyalkylsiloxanes et perhydropolysilazanes.

9. Procédé selon la revendication 7 ou 8, **caractérisé en ce que** la mise en contact (a) de ladite surface avec le ou lesdits précurseurs du matériau non nucléant est effectuée par trempage, tournage, pistolétage ou application au pinceau d'une solution liquide comprenant le ou lesdits précurseurs.

10. Procédé selon l'une quelconque des revendications 7 à 9, **caractérisé en ce que** ledit traitement thermique (b) comprend le chauffage à une température allant de 300 à 700 °C, en particulier sous atmosphère contrôlée, notamment sous atmosphère d'azote ou sous air.

11. Procédé selon l'une quelconque des revendications 7 à 10, comprenant, en outre, à l'issue de l'étape b), un traitement thermique additionnel, sous atmosphère oxydante, pendant au moins une heure et à une température d'au moins 1000°C.

12. Procédé selon l'une quelconque des revendications 5 à 11, **caractérisé en ce que** ledit traitement de surface de l'étape (ii) est effectué par attaque chimique, notamment par voie humide, et en particulier, dans le cas où ledit matériau non nucléant est formé d'oxyde de silicium, par attaque chimique à l'aide d'une solution d'acide fluorhydrique.

13. Procédé selon l'une quelconque des revendications 5 à 11, **caractérisé en ce que** ledit traitement de l'étape (ii) est opéré par attaque directionnelle par plasma, en particulier par plasma d'argon.

14. Procédé selon l'une quelconque des revendications précédentes, dans lequel l'étape (3) est effectuée par épitaxie en phase liquide, en particulier à partir d'un bain liquide comprenant du silicium et un solvant comme par exemple l'étain.

15. Procédé selon l'une quelconque des revendications 1 à 13, dans lequel l'étape (3) est effectuée par épitaxie en phase gazeuse, en particulier mettant en oeuvre du trichorosilane comme précurseur.

16. Procédé selon l'une quelconque des revendications précédentes, dans lequel ladite couche de silicium épitaxiée obtenue à l'issue de l'étape (3) présente une taille de cristallites supérieure ou égale à 50 µm, en particulier supérieure ou égale à 100 µm.

## Patentansprüche

1. Verfahren zur Herstellung einer epitaxialen Siliciumschicht, die aus Kristalliten mit einer Größe von größer oder gleich 20 µm gebildet wird, umfassend mindestens die folgenden Schritte:
(1) Anordnen einer kristallisierten Siliciumschicht, deren bezüglich der Größe von Kristalliten inhomogene Oberfläche aus folgendem gebildet wird:
- großen Kristalliten mit einer Größe von größer oder gleich 20 µm, die auf der Oberfläche nicht kontinuierlich verteilt sind, wobei der mittlere seitliche Abstand zwischen zwei großen benachbarten Kristalliten nicht über 200 µm beträgt; und
- kleinen Kristalliten mit einer Größe unterhalb derjenigen der großen Kristalliten, die in einem Oberflächen-Anteil von nicht über 60 % der Oberfläche vorhanden sind;
(2) Bilden, auf der Oberfläche der inhomogenen Siliciumschicht, einer Schicht aus mindestens einem für Silicium nicht nukleierenden Material, deren Dicke eingestellt ist, um die gesamte äußere Fläche der kleinen Kristalliten zu bedecken, unter gleichzeitiger Freilassung der gesamten oder eines Teils der äußeren Fläche der großen Kristalliten; und
(3) Realisieren des epitaxialen Wachstums einer Siliciumschicht auf der Oberfläche der aus Schritt (2) erhaltenen Einheit unter Bedingungen, die für die Bildung der erwarteten epitaxialen Schicht günstig sind.

2. Verfahren nach Anspruch 1, **dadurch gekennzeichnet, dass** die großen Kristallite der Oberfläche von Schritt (1) pyramidal geformt sind.

3. Verfahren nach Anspruch 1 oder 2, **dadurch gekennzeichnet, dass** der mittlere seitliche Abstand zwischen zwei großen benachbarten Kristalliten der Oberfläche von Schritt (1) im Bereich von 1 bis 200 µm, insbesondere von 20 bis 100 µm beträgt.

4. Verfahren nach einem der vorangehenden Ansprüche, **dadurch gekennzeichnet, dass** der Oberflächen-Anteil der kleinen Kristalliten von Schritt (1) im Bereich von 1 bis 60 %, insbesondere 10 bis 40 % der Oberfläche beträgt.

5. Verfahren nach einem der vorangehenden Ansprüche, wobei der Schritt (2) mindestens die folgenden Schritte umfasst:
(i) Bilden einer Schicht aus mindestens einem für Silicium nicht nukleierenden Material auf der Oberfläche von Schritt (1), wobei die Schicht mindestens die gesamte äußere Fläche der kleinen Kristalliten bedeckt; und
(ii) Exponieren der beschichteten Oberfläche von Schritt (i) gegenüber einer Oberflächenbehandlung, die für die Beseitigung der Schicht von nicht nukleierendem Material günstig ist, auf der gesamten oder auf einem Teil der äußeren Oberfläche der großen Kristallite.

6. Verfahren nach einem der vorangehenden Ansprüche, wobei das für Silicium nicht nukleierende Material ein keramisches Material ist, das insbesondere ausgewählt ist aus Verbindungen der allgemeinen Formel SiOₓN_{y}C_{z}, wobei x größer oder gleich 0,1, vorzugsweise größer oder gleich 0,3 ist, y und z jeweils größer oder gleich 0 sind.

7. Verfahren nach Anspruch 5 oder 6, wobei der Schritt (i) folgendes umfasst (a) Inkontaktbringen der zu behandelnden Oberfläche mit einem oder mehreren Vorläufern des nicht nukleierenden Materials, das insbesondere aus Organosiliciumpolymeren ausgewählt ist, und (b) Wärmebehandlung der durch die Oberfläche in Kontakt mit dem oder den Vorläufer(n) gebildeten Einheit, die zur Bildung der Schicht aus nicht nukleierendem Material günstig ist, insbesondere durch Kondensations-Vernetzung, wobei die Schritte (a) und (b) aufeinanderfolgend oder gleichzeitig erfolgen.

8. Verfahren nach dem vorangehenden Anspruch, wobei das oder die Organosiliciumpolymer(e) ausgewählt ist (sind) aus Polysilazan(en) und/oder Polysiloxan(en), und spezieller aus Polyalkylsiloxanen und Perhydropolysilazanen.

9. Verfahren nach Anspruch 7 oder 8, **dadurch gekennzeichnet, dass** das Inkontaktbringen (a) der Oberfläche mit dem oder den Vorläufern des nicht nukleierenden Materials durch Tempern, Drehen, Sprühen oder Bürstenauftrag einer flüssigen Lösung, die den oder die Vorläufer umfasst, durchgeführt wird.

10. Verfahren nach einem der Ansprüche 7 bis 9, **dadurch gekennzeichnet, dass** die Wärmebehandlung (b) das Erwärmen auf eine Temperatur von 300 bis 700°C, insbesondere unter kontrollierter Atmosphäre, insbesondere unter Stickstoffatmosphäre oder unter Luft umfasst.

11. Verfahren nach einem der Ansprüche 7 bis 10, umfassend weiterhin nach Schritt b) eine zusätzliche Wärmebehandlung unter oxidierender Atmosphäre, während mindestens einer Stunde und bei einer Temperatur von mindestens 1000 °C.

12. Verfahren nach einem der Ansprüche 5 bis 11, **dadurch gekennzeichnet, dass** die Oberflächenbehandlung des Schritts (ii) durch chemischen Angriff, insbesondere feucht, und insbesondere im Falle, wobei das nicht nukleierende Material aus Siliciumoxid gebildet ist, durch chemischen Angriff mit Hilfe einer Fluorwasserstoffsäurelösung durchgeführt wird.

13. Verfahren nach einem der Ansprüche 5 bis 11, **dadurch gekennzeichnet, dass** die Oberflächenbehandlung des Schritts (ii) durch gezielten Plasmaangriff, insbesondere durch Argonplasma durchgeführt wird.

14. Verfahren nach einem der vorangehenden Ansprüche, wobei der Schritt (3) durch Flüssigphasen-Epitaxie, insbesondere in einem Flüssigbad, das Silizium und ein Lösungsmittel wie beispielsweise Zinn umfasst, durchgeführt wird.

15. Verfahren nach einem der Ansprüche 1 bis 13, wobei der Schritt (3) durch Gasphasen-Epitaxie, insbesondere unter Einsatz von Trichlorsilan als Vorläufer durchgeführt wird.

16. Verfahren nach einem der vorangehenden Ansprüche, wobei die aus Schritt (3) erhaltene epitaxiale Siliciumschicht eine Kristalliten-Größe von größer oder gleich 50 µm, insbesondere von größer oder gleich 100 µm aufweist.

## Claims

1. A process for forming an epitaxial silicon layer formed of crystallites having a size of greater than or equal to 20 µm, comprising at least the steps consisting in:
(1) providing a layer of crystalline silicon, the surface of which, inhomogeneous in terms of crystallite size, is formed:
- of large crystallites having a size of greater than or equal to 20 µm, distributed over said surface in a non-continuous manner, the mean lateral spacing between two neighboring large crystallites not exceeding 200 µm; and
- of small crystallites having a size smaller than that of the large crystallites, present in a surface fraction that does not exceed 60% of said surface;
(2) forming, at the surface of said inhomogeneous silicon layer, a layer of at least one material that is not nucleating for silicon and the thickness of which is adjusted to cover the whole of the outer surface of said small crystallites while leaving all or part of the outer surface of said large crystallites accessible; and
(3) carrying out the epitaxial growth of a layer of silicon at the surface of the assembly obtained at the end of step (2), under conditions suitable for the formation of said expected epitaxial layer.

2. The process as claimed in claim 1, **characterized in that** said large crystallites of said surface from step (1) are of pyramidal shape.

3. The process as claimed in claim 1 or 2, **characterized in that** the mean lateral spacing between two neighboring large crystallites of said surface from step (1) ranges from 1 to 200 µm, in particular from 20 to 100 µm.

4. The process as claimed in any one of the preceding claims, **characterized in that** the surface fraction of said small crystallites from step (1) ranges from 1% to 60%, in particular from 10% to 40%, of said surface.

5. The process as claimed in any one of the preceding claims, wherein step (2) comprises at least the steps consisting of:
(i) forming a layer of at least one material that is not nucleating for silicon on said surface from step (1), said layer covering at least the whole of the outer surface of said small crystallites; and
(ii) exposing said coated surface from step (i) to a surface treatment suitable for the removal of the layer of non-nucleating material over all or part of the outer surface of said large crystallites.

6. The process as claimed in any one of the preceding claims, wherein said material that is not nucleating for silicon is a ceramic material, in particular selected from the compounds of general formula SiOₓN_{y}C_{z}, with x being greater than or equal to 0.1, preferably greater than or equal to 0.3, y and z each being greater than or equal to 0.

7. The process as claimed in claim 5 or 6, wherein step (i) comprises (a) bringing said surface to be treated into contact with one or more precursors of said non-nucleating material, in particular selected from organosilicon polymers, and (b) the heat treatment of the assembly formed by said surface in contact with said precursor(s), suitable for the formation of said layer of non-nucleating material, in particular by condensation-crosslinking, the steps (a) and (b) being consecutive or simultaneous.

8. The process as claimed in the preceding claim, wherein said organosilicon polymer(s) is/are selected from polysilazane(s) and/or polysiloxane(s), and more particularly from polyalkylsiloxanes and perhydropolysilazanes.

9. The process as claimed in claim 7 or 8, **characterized in that** bringing said surface into contact with said precursor(s) of the non-nucleating material (a) is carried out by dip coating, spin coating, spray coating or brush application of a liquid solution comprising said precursor(s).

10. The process as claimed in any one of claims 7 to 9, **characterized in that** said heat treatment (b) comprises heating at a temperature ranging from 300°C to 700°C, in particular under a controlled atmosphere, especially under a nitrogen atmosphere or in air.

11. The process as claimed in any one of claims 7 to 10, comprising, in addition, at the end of step b), an additional heat treatment, under an oxidizing atmosphere, for at least one hour and at a temperature of at least 1000°C.

12. The process as claimed in any one of claims 5 to 11, **characterized in that** said surface treatment from step (ii) is carried out by etching, especially wet etching, and in particular, in the case where said non-nucleating material is formed of silicon oxide, by etching using a solution of hydrofluoric acid.

13. The process as claimed in any one of claims 5 to 11, **characterized in that** said treatment from step (ii) is carried out by directional plasma etching, in particular argon plasma etching.

14. The process as claimed in any one of the preceding claims, wherein step (3) is carried out by liquid phase epitaxy, in particular using a liquid bath comprising silicon and a solvent such as for example tin.

15. The process as claimed in any one of claims 1 to 13, wherein step (3) is carried out by vapor phase epitaxy, in particular using trichlorosilane as precursor.

16. The process as claimed in any one of the preceding claims, wherein said epitaxial silicon layer obtained at the end of step (3) has a crystallite size of greater than or equal to 50 µm, in particular of greater than or equal to 100 µm.
